# EUROPEAN PATENT APPLICATION

(11) **EP 4 273 733 A1**
(43) Date of publication of application: **08.11.2023**
(21) Application number: 23164695.1
(22) Date of filing: 28.03.2023
(51) Int. Cl.: G06F 30/20, B60W 60/00, G06F 119/02

(54) **INCREASING AUTONOMOUS VEHICLE LOG DATA USEFULNESS VIA PERTURBATION**

(30) Priority: 06.05.2022 US 202217738660
(71) Applicant: WAYMO LLC, Mountain View, CA 94043 (US)
(72) Inventor: LAU, Matthew, Mountain View, 94043 (US); LIU, Jiabin, Mountain View, 94043 (US); LIU, Xiaoyi, Mountain View, 94043 (US)
(74) Representative: Anderson, Oliver Ben

(57) **Abstract**

A method includes receiving a set of real-world log data defining a real-world driving environment and generated by an autonomous vehicle (AV). The set of real-world log data includes at least one set of real-world parameters defining at least one real-world object observed by the AV operating within the real-world driving environment. The method further includes generating, based on the set of real-world log data, a set of simulated log data defining a simulated driving environment and causing a simulation to be performed using the set of simulated log data. The set of simulated log data comprises at least one set of simulated parameters defining at least one simulated object within the simulated driving environment, and generating the set of simulated log data includes perturbing at least one real-world parameter of the at least one set of real-world parameters to obtain the at least one set of simulated parameters.

## Description

### TECHNICAL FIELD

The instant specification generally relates to autonomous vehicles (AVs). More specifically, the instant specification relates to increasing AV log data usefulness via perturbation.

### BACKGROUND

An autonomous (fully and partially self-driving) vehicle (AV) operates by sensing an outside environment with various electromagnetic (e.g., radar and optical) and non-electromagnetic (e.g., audio and humidity) sensors. Some autonomous vehicles chart a driving path through the environment based on the sensed data. The driving path can be determined based on Global Positioning System (GPS) data and road map data. While the GPS and the road map data can provide information about static aspects of the environment (buildings, street layouts, road closures, etc.), dynamic information (such as information about other vehicles, pedestrians, streetlights, etc.) is obtained from contemporaneously collected sensing data. Precision and safety of the driving path and of the speed regime selected by the autonomous vehicle depend on timely and accurate identification of various objects present in the driving environment and on the ability of a driving algorithm to process the information about the environment and to provide correct instructions to the vehicle controls and the drivetrain.

### SUMMARY

In one implementation, disclosed is a system including a memory device and a processing device, operatively coupled to the memory device, to perform operations including receiving a set of real-world log data defining a real-world driving environment and generated by an autonomous vehicle (AV). The set of real-world log data includes at least one set of real-world parameters defining at least one real-world object observed by the AV operating within the real-world driving environment. The operations further include generating, based on the set of real-world log data, a set of simulated log data defining a simulated driving environment, and causing a simulation to be performed using the set of simulated log data to obtain a simulation output. The set of simulated log data includes at least one set of simulated parameters defining at least one simulated object within the simulated driving environment, and generating the set of simulated log data includes perturbing at least one real-world parameter of the at least one set of real-world parameters to obtain the at least one set of simulated parameters.

In another implementation, disclosed is a method. The method includes receiving, by a processing device, a set of real-world log data defining a real-world driving environment and generated by an autonomous vehicle (AV). The set of real-world log data includes at least one set of real-world parameters defining at least one real-world object observed by the AV operating within the real-world driving environment. The method further includes generating, by the processing device based on the set of real-world log data, a set of simulated log data defining a simulated driving environment, and causing, by the processing device, a simulation to be performed using the set of simulated log data to obtain a simulation output. The set of simulated log data includes at least one set of simulated parameters defining at least one simulated object within the simulated driving environment, and generating the set of simulated log data includes perturbing at least one real-world parameter of the at least one set of real-world parameters to obtain the at least one set of simulated parameters.

In yet another implementation, disclosed is a non-transitory computer-readable storage medium having instructions stored thereon that, when executed by a processing device, cause the processing device to perform operations including generating, based on a set of real-world log data defining a real-world driving environment and generated by an autonomous vehicle (AV), a set of simulated log data defining a simulated driving environment. The set of simulated log data includes at least one set of simulated parameters defining at least one simulated object within the simulated driving environment, and generating the set of simulated log data includes perturbing at least one real-world parameter of the at least one set of real-world parameters to obtain the at least one set of simulated parameters. The operations further include causing a simulation to be performed using the set of simulated log data to obtain a simulation output reflecting AV performance within the simulated driving environment, determining whether the simulation output indicates that the AV performance satisfies a threshold condition, in response to determining that the simulation output indicates that the AV performance does not satisfy the threshold condition, identifying an update to a component of the AV that was used during the simulation as a failed update, and addressing the failed update.

### BRIEF DESCRIPTION OF THE DRAWINGS

The disclosure is illustrated by way of examples, and not by way of limitation, and can be more fully understood with references to the following detailed description when considered in connection with the figures, in which:
**FIG. 1** is a diagram illustrating components of an example autonomous vehicle, in accordance with some implementations of the present disclosure.
**FIG. 2** is a diagram illustrating an example system for performing an autonomous vehicle (AV) driving simulation, in accordance with some implementations of the present disclosure.
**FIG. 3** is a diagram illustrating an example system for performing and implementing an autonomous vehicle (AV) driving simulation, in accordance with some implementations of the present disclosure.
**FIG. 4** is a diagram illustrating an example real-world driving environment, in accordance with some implementations of the present disclosure.
**FIG. 5** is a diagram illustrating an example simulated driving environment, in accordance with some implementations of the present disclosure.
**FIG. 6** is a flow diagram of an example method of increasing autonomous vehicle (AV) log data usefulness via perturbation, in accordance with some implementations of the present disclosure.
**FIG. 7** is a block diagram of an example computer device within which a set of instructions, for causing the machine to perform any of the one or more methodologies discussed herein can be executed, in accordance with some implementations of the disclosure.

### DETAILED DESCRIPTION

An autonomous vehicle (AV) performs vehicle actions, such as braking, steering, and throttling, to move the AV from the starting location to the destination location along the route. The AV can include a planning module that receives route data (e.g., from a server) that includes particular roads to travel from the starting location to the destination location. The planning module (also referred to herein as a "routing module") receives sensor data from the perception system (e.g., vehicle sensors) that indicates locations of other objects. The routing module uses the sensor data, the route data and predictions about how various objects of the AV driving environment will be positioned to generate short time horizon routing data. The short time horizon routing data includes instructions of how to control the AV over a short interval of time (e.g., the next 10 seconds). The short time horizon routing data may be generated (e.g., regenerated, refreshed) very frequently (e.g., every 100 milliseconds (ms)). By being generated very frequently, the short time horizon routing data can reflect substantially all the changes in the vehicle or the world (e.g., engine degradation, other objects changing course or speed or appearing suddenly). The routing module provides the short time horizon routing data to a motion control module. The motion control module controls the vehicle systems over the next interval of time (e.g., the next 10 seconds, next 100 ms) based on the short time horizon routing data. The routing module continues generating (e.g., refreshing) new short time horizon routing data for the subsequent intervals of time based on the route data and the current sensor data from the perception system. The motion control module continues controlling the vehicle based on the new short time horizon routing data.

While operating with a driving environment (e.g., an interaction, a highway, a construction zone, or other type of scene), an AV control system can respond to and interact with objects, such as agents (vehicles, pedestrians, bicyclists, animals, etc.), traffic lights, cones, signs, etc. The AV control system can be tested and validated before being implemented within the AV to improve how the AV responds to interactions with objects. Due to a potential lack of real-world data points from which to model interactions between an AV and objects, AV motion planning or navigation methods can involve utilization of simulation data derived from AV simulations ("simulations"). A simulation can be used to model the behavior of the AV control system using a set of simulated data. For example, in log-based simulations, the set of simulated data can include a set of simulated log data. The set of simulated data can include at least one set of simulated parameters. Each set of simulated parameters can define a feature of a simulated driving environment. For example, a set of simulated parameters can define the type of simulated driving environment (e.g., an intersection, a highway, a construction zone, or other environment), or a simulated object within the simulated driving environment (e.g., simulated agent, traffic light, cone, sign).

A simulation may be analyzed to observe behaviors (e.g., trajectory behaviors of the simulated AV and/or simulated agents) and detect events or interactions that have occurred during the simulation. For example, an event can be a negative event (e.g., a collision or near collision). These behaviors and events may be used for various purposes, such as determining whether the AV control system (e.g., software) can "pass" the simulation without a collision or near collision and to pinpoint the types of behaviors and/or software modules that may need attention in order to improve performance and safety, without requiring a vehicle to physically drive "real" miles or having to "manufacture" real-world situations.

One type of AV simulation is log-based simulation, which performs a simulation based on simulated log data. It can take a large number of simulations to adequately test the ability of the AV control software to handle a large number of different driving scenarios. Moreover, the simulated log data used to perform a simulation should model realistic driving scenarios that may be observed by an AV in a real-world driving scenario. For example, having simulated log data that observes a pedestrian moving at a speed of 30 miles per hour would not be realistic. Additionally, simulated log data can include a number of parameters that are interrelated. For example, there may be a relationship between the height of a pedestrian and the speed of the pedestrian as the pedestrian is crossing a street. Thus, generating simulated data by randomly generating parameter values can lead to unrealistic simulated datasets and corresponding irrelevant simulations. A lack of mechanisms exists to efficiently obtain a large amount of realistic simulated log data in a reliable manner for testing AV control software and improving AV control systems implementing the AV control software.

Aspects of the disclosure address the above challenges, along with others, by increasing autonomous vehicle (AV) log data usefulness via perturbation. A set of real-world log data can be collected based on an AV operating in an autonomous mode within a real-world driving environment. For example, the set of real-world log data can be collected over some brief period of time (e.g., less than or equal to 1 minute). The set of real-world log data can include information from various AV systems, including perception, routing, planning, positioning, etc.

A processing device can receive the set of real-world log data, and can perform a number of perturbations with respect to the set of real-world log data to generate a corresponding number of sets of simulated log data. Perturbation refers to a deviation or change to data. In some implementations, the set of real-world log data can include at least one set of real-world parameters defining at least one real-world object observed by an AV operating within a real-world driving environment, and each set of simulated log data can include at least one set of simulated parameters defining at least one simulated object observed by an AV operating within a simulated driving environment. For example, a set of real-world parameters can define a trajectory of a real-world object observed by an AV within a real-world driving environment, and a set of simulated parameters can define a trajectory of a simulated object observed by an AV within a simulated driving environment.

Generating a set of simulated parameters defining a simulated object can include perturbing at least one parameter of a corresponding set of real-world parameters defining a corresponding real-world object. The perturbations can be performed by using a noise injector implemented by the simulated data generator. For example, a set of input data can be received by the simulated data generator. The set of input data can include, for example, a log object identifier (ID) and the parameter(s) to be perturbed. The deviations or changes between the set of real-world parameters and each set of simulated parameters can be sufficiently small to help ensure that each set of simulated log data is capable of being observed by the AV while operating in a real-world driving environment (e.g., that each set of simulated parameters is sufficiently realistic). For example, in some implementations, the trajectory of the simulated object can be similar to the trajectory of the corresponding real-world object.

In some implementations, the simulated object can be the same type of object as the real-world object. In some implementations, the simulated object can have a type different from the real-world object (e.g., the real-world object is replaced with a different type of object having a similar trajectory). The simulated object can follow a similar trajectory with respect to the real-world object. For example, perturbing the at least one parameter of the set of real-world parameters to generate the set of simulated parameters can include at least one of: physically shifting the AV trajectory and/or the object trajectory (e.g. laterally and/or longitudinally), temporally shifting the AV trajectory and/or the object trajectory, changing AV speed and/or object speed, changing one or more object dimensions (e.g., length, width and/or height), or changing the object type.

For example, speed multiplier perturbation can be used to multiply the speed of the real-world object at each time frame by a speed multiplier value. A number of speed multiplier values can be used to generate different sets of simulated data. In some implementations, the speed multiplier values can range between about 0.6 to about 1.4, inclusive. For example, the speed multiplier values can be selected from the set {0.6, 0.8, 1, 1.2, 1.4}. In some implementations, the speed multiplier value can range between about 0.9 to about 1.1. For example, the speed multiplier values can be selected from the set {0.9, 1, 1.1}.

As another example, object spawn time perturbation can be used to change the spawn time of an object by an object spawn time perturbation value. Object spawn time perturbation can be viewed as a type of object trajectory temporal shift. Thus, if the other parameters of the set of real-world parameters remain untouched, then the simulated object can follow the same action as the real-world object, just at a different time step. In some implementations, the object spawn time perturbation values can range between about -1 second to about 1 second. For example, the object spawn time perturbation values can be selected from the set {-1 second, -0.5 second, 0 seconds, 0.5 second, 1 second}.

Illustratively, consider a driving environment in which an AV has generated a set of real-world log data including a set of real-world parameters defining a jaywalking pedestrian ("jaywalker") observed to cross at an intersection. The set of real-world parameters can further include a set of jaywalker parameters, such as dimensions (e.g., size) of the jaywalker, a trajectory of the jaywalker crossing the crosswalk, a trajectory of the AV, etc. At least one perturbation can be performed to at least one parameter of the set of jaywalker parameters to generate at least one set of simulated jaywalker parameters.

Examples of perturbations that can be performed to generate the set of simulated jaywalker parameters can include a physical shift of the AV trajectory (e.g. laterally and/or longitudinally), a physical shift of the jaywalker trajectory (e.g., shifting the jaywalker to a nearby crosswalk), a temporal shift of the AV trajectory and/or jaywalker trajectory (e.g., having the jaywalker cross earlier or later relative to the real-world log data), a change in speed of the AV and/or the jaywalker (e.g., the jaywalker may cross a crosswalk faster or slower), a change in object dimensions (e.g. height of the jaywalker). Additionally or alternatively, the jaywalker can be replaced with a different type of agent following a similar trajectory as the jaywalker. For example, the jaywalker can be replaced with a cyclist, an animal, etc. Accordingly, real-world log data can be provided as input to a simulated log generator, and the simulated log generator can generate a variety of different sets of simulated log data by modifying one or more parameters of the real-world log data.

The processing device can, for each set of simulated log data, perform a simulation using the set of simulated log data to generate a simulation output that indicates how AV control system software being tested is performing. Each set of simulated log data can define a different simulated driving environment and interaction between the AV control system software and the simulated driving environment. For example, a simulation output for a set of simulated log data can reflect a performance of the simulated AV operating within a simulated driving environment defined by the set of simulated log data. The performance can be compared to a threshold condition to determine whether the performance satisfies the threshold condition. For example, the simulation output can include a number of negative events caused by AV errors (e.g., a number of collisions and/or near collisions), and the performance can be determined to satisfy the threshold condition if the number of negative events is less than or equal to a threshold number of negative events (e.g., a maximum number of negative events).

If the performance does not satisfy a threshold condition (e.g., the number of negative events is greater than the threshold number of negative events), then it is determined that the AV control software has failed to safely operate the AV within the simulated driving environment. The failed AV control software may be annotated or flagged for additional consideration, etc. The failed AV control software may be further analyzed to review metrics other than collision data, such as comfort, stranding, safety risk, etc. in order to evaluate the software. The AV control software can then be modified or updated to improve the operation of the AV within the driving environment defined by the set of simulated log data.

In some implementations, if the AV control software being tested during simulation is an update to a particular program, module, machine learning model or the like, and the simulation output indicates that performance of the simulated AV operating within the simulated driving environment satisfies the threshold condition (e.g., the number of negative events is less than or equal to the threshold number of negative events), then the updated AV control software is determined to have succeeded in safely operating the AV within the simulated driving environment. That is, the updated AV control software has been deemed validated, at least for the passing simulation. Accordingly, the update can be integrated into the AV control system to improve the ability of the AV control system to interact and respond to objects within a driving environment.

In some implementations, if the current AV control software is being tested during simulation, and the simulation output indicates that performance of the simulated AV operating within the simulated driving environment satisfies the threshold condition (e.g., the number of negative events is less than or equal to the threshold number of negative events), then the current AV control software is determined to have succeeded in safely operating the AV within the simulated driving environment. That is, the current AV control software has been deemed validated, at least for the passing simulation, and no change to the current AV control software is needed. Alternatively, if the current AV control software is being tested during simulation, and the simulation output indicates that performance of the simulated AV operating within the simulated driving environment does not satisfy the threshold condition (e.g., the number of negative events is higher than the threshold number of negative events), then the current AV control software is determined to have failed in safely operating the AV within the simulated driving environment. That is, the current AV control software has been deemed invalidated for failing simulation, thereby indicating that the current AV control software needs to be updated to improve the ability of the AV control system to interact and respond to objects within a driving environment.

Aspects and implementations disclosed herein provide numerous advantages over existing technologies. For example, perturbing real-world log data in accordance with implementations described herein can enable the generation of a large number of simulated log data sets that can be used during simulations performed to test and improve AV control software. Generating simulated log data in accordance with implementations described herein may provide for safe and effective ways of testing the AV control software to identify potential critical bugs with the software for outlier situations. Further, by perturbing real-world log data, "new" simulations can be created which allow for analysis of any number of potential safety issues without having to obtain new real-world log data and/or manufacture simulated log data from the ground up. Other benefits may include the ability of a software developer to experiment with object (e.g., agent) behavior changes and display realistic examples of how the behavior changes impact AV operation. The improvements to the AV control software can improve the operation of an AV within driving environments, such as by causing the AV to react to objects in the driving environment more promptly, causing the AV to follow a more natural motion trajectory, reducing stranding behavior, etc.

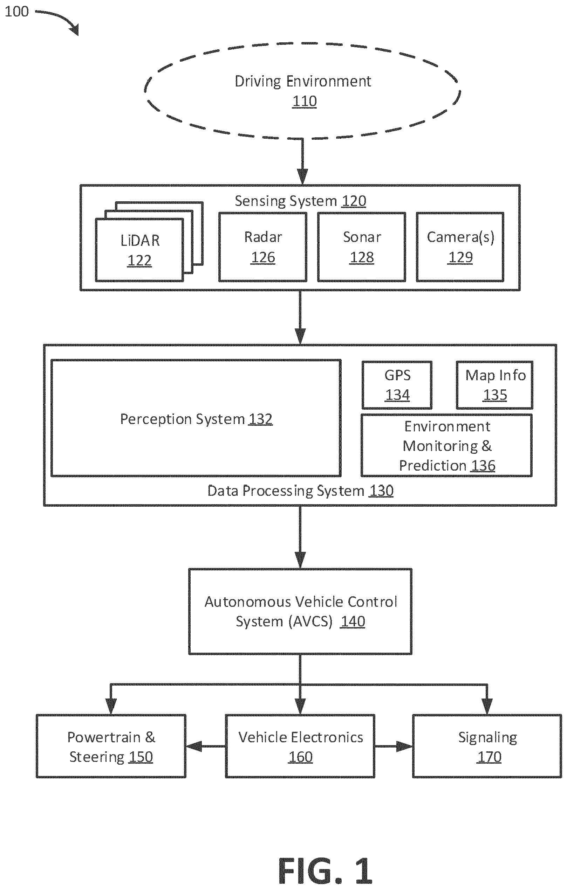

**FIG. 1** is a diagram illustrating components of an example autonomous vehicle (AV) 100 capable of using motion patterns for object classification and tracking, in accordance with some implementations of the present disclosure. **FIG. 1** illustrates operations of the example autonomous vehicle. Autonomous vehicles can include motor vehicles (cars, trucks, buses, motorcycles, all-terrain vehicles, recreational vehicle, any specialized farming or construction vehicles, and the like), aircraft (planes, helicopters, drones, and the like), naval vehicles (ships, boats, yachts, submarines, and the like), or any other self-propelled vehicles (e.g., sidewalk delivery robotic vehicles) capable of being operated in a self-driving mode (without a human input or with a reduced human input).

Vehicles, such as those described herein, may be configured to operate in one or more different driving modes. For instance, in a manual driving mode, a driver may directly control acceleration, deceleration, and steering via inputs such as an accelerator pedal, a brake pedal, a steering wheel, etc. A vehicle may also operate in one or more autonomous driving modes including, for example, a semi or partially autonomous driving mode in which a person exercises some amount of direct or remote control over driving operations, or a fully autonomous driving mode in which the vehicle handles the driving operations without direct or remote control by a person. These vehicles may be known by different names including, for example, autonomously driven vehicles, self-driving vehicles, and so on.

As described herein, in a semi-autonomous or partially autonomous driving mode, even though the vehicle assists with one or more driving operations (e.g., steering, braking and/or accelerating to perform lane centering, adaptive cruise control, advanced driver assistance systems (ADAS), or emergency braking), the human driver is expected to be situationally aware of the vehicle's surroundings and supervise the assisted driving operations. Here, even though the vehicle may perform all driving tasks in certain situations, the human driver is expected to be responsible for taking control as needed.

Although, for brevity and conciseness, various systems and methods may be described below in conjunction with autonomous vehicles, similar techniques can be used in various driver assistance systems that do not rise to the level of fully autonomous driving systems. In the United States, the Society of Automotive Engineers (SAE) have defined different levels of automated driving operations to indicate how much, or how little, a vehicle controls the driving, although different organizations, in the United States or in other countries, may categorize the levels differently. More specifically, disclosed systems and methods can be used in SAE Level 2 driver assistance systems that implement steering, braking, acceleration, lane centering, adaptive cruise control, etc., as well as other driver support. The disclosed systems and methods can be used in SAE Level 3 driving assistance systems capable of autonomous driving under limited (e.g., highway) conditions. Likewise, the disclosed systems and methods can be used in vehicles that use SAE Level 4 self-driving systems that operate autonomously under most regular driving situations and require only occasional attention of the human operator. In all such driving assistance systems, accurate lane estimation can be performed automatically without a driver input or control (e.g., while the vehicle is in motion) and result in improved reliability of vehicle positioning and navigation and the overall safety of autonomous, semi-autonomous, and other driver assistance systems. As previously noted, in addition to the way in which SAE categorizes levels of automated driving operations, other organizations, in the United States or in other countries, may categorize levels of automated driving operations differently. Without limitation, the disclosed systems and methods herein can be used in driving assistance systems defined by these other organizations' levels of automated driving operations.

A driving environment 110 can include any objects (animated or non-animated) located outside the AV, such as roadways, buildings, trees, bushes, sidewalks, bridges, mountains, other vehicles, pedestrians, and so on. The driving environment 110 can be urban, suburban, rural, and so on. In some implementations, the driving environment 110 can be an off-road environment (e.g. farming or agricultural land). In some implementations, the driving environment can be an indoor environment, e.g., the environment of an industrial plant, a shipping warehouse, a hazardous area of a building, and so on. In some implementations, the driving environment 110 can be substantially flat, with various objects moving parallel to a surface (e.g., parallel to the surface of Earth). In other implementations, the driving environment can be three-dimensional and can include objects that are capable of moving along all three directions (e.g., balloons, leaves, etc.). Hereinafter, the term "driving environment" should be understood to include all environments in which an autonomous motion of self-propelled vehicles can occur. For example, "driving environment" can include any possible flying environment of an aircraft or a marine environment of a naval vessel. The objects of the driving environment 110 can be located at any distance from the AV, from close distances of several feet (or less) to several miles (or more).

The example AV 100 can include a sensing system 120. The sensing system 120 can include various electromagnetic (e.g., optical) and non-electromagnetic (e.g., acoustic) sensing subsystems and/or devices. The terms "optical" and "light," as referenced throughout this disclosure, are to be understood to encompass any electromagnetic radiation (waves) that can be used in object sensing to facilitate autonomous driving, e.g., distance sensing, velocity sensing, acceleration sensing, rotational motion sensing, and so on. For example, "optical" sensing can utilize a range of light visible to a human eye (e.g., the 380 to 700 nm wavelength range), the ultraviolet range (below 380 nm), the infrared range (above 700 nm), the radio frequency range (above 1 m), etc. In implementations, "optical" and "light" can include any other suitable range of the electromagnetic spectrum.

The sensing system 120 can include a radar unit 126, which can be any system that utilizes radio or microwave frequency signals to sense objects within the driving environment 110 of the AV 100. The radar unit can be configured to sense both the spatial locations of the objects (including their spatial dimensions) and their velocities (e.g., using the Doppler shift technology). Hereinafter, "velocity" refers to both how fast the object is moving (the speed of the object) as well as the direction of the object's motion.

The sensing system 120 can include one or more lidar sensors 122 (e.g., lidar rangefinders), which can be a laser-based unit capable of determining distances (e.g., using ToF technology) to the objects in the driving environment 110. The lidar sensor(s) can utilize wavelengths of electromagnetic waves that are shorter than the wavelength of the radio waves and can, therefore, provide a higher spatial resolution and sensitivity compared with the radar unit. The lidar sensor(s) can include a coherent lidar sensor, such as a frequency-modulated continuous-wave (FMCW) lidar sensor. The lidar sensor(s) can use optical heterodyne detection for velocity determination. In some implementations, the functionality of a ToF and coherent lidar sensor(s) is combined into a single (e.g., hybrid) unit capable of determining both the distance to and the radial velocity of the reflecting object. Such a hybrid unit can be configured to operate in an incoherent sensing mode (ToF mode) and/or a coherent sensing mode (e.g., a mode that uses heterodyne detection) or both modes at the same time. In some implementations, multiple lidar sensor(s) 122 units can be mounted on AV, e.g., at different locations separated in space, to provide additional information about a transverse component of the velocity of the reflecting object, as described in more detail below.

The lidar sensor(s) 122 can include one or more laser sources producing and emitting signals and one or more detectors of the signals reflected back from the objects. The lidar sensor(s) 122 can include spectral filters to filter out spurious electromagnetic waves having wavelengths (frequencies) that are different from the wavelengths (frequencies) of the emitted signals. In some implementations, the lidar sensor(s) 122 can include directional filters (e.g., apertures, diffraction gratings, and so on) to filter out electromagnetic waves that can arrive at the detectors along directions different from the retro-reflection directions for the emitted signals. The lidar sensor(s) 122 can use various other optical components (lenses, mirrors, gratings, optical films, interferometers, spectrometers, local oscillators, and the like) to enhance sensing capabilities of the sensors.

In some implementations, the lidar sensor(s) 122 can scan 360-degree in a horizontal direction. In some implementations, the lidar sensor(s) 122 can be capable of spatial scanning along both the horizontal and vertical directions. In some implementations, the field of view can be up to 90 degrees in the vertical direction (e.g., with at least a part of the region above the horizon being scanned by the lidar signals). In some implementations, the field of view can be a full sphere (consisting of two hemispheres). For brevity and conciseness, when a reference to "lidar technology," "lidar sensing," "lidar data," and "lidar," in general, is made in the present disclosure, such reference shall be understood also to encompass other sensing technology that operate at generally in the near-infrared wavelength, but may include sensing technology that operate at other wavelengths.

The sensing system 120 can further include one or more cameras 129 to capture images of the driving environment 110. The images can be two-dimensional projections of the driving environment 110 (or parts of the driving environment 110) onto a projecting plane (flat or non-flat, e.g. fisheye) of the cameras. Some of the cameras 129 of the sensing system 120 can be video cameras configured to capture a continuous (or quasi-continuous) stream of images of the driving environment 110. The sensing system 120 can also include one or more sonars 128, which can be ultrasonic sonars, in some implementations.

The sensing data obtained by the sensing system 120 can be processed by a data processing system 130 of AV 100. For example, the data processing system 130 can include a perception system 132. The perception system 132 can be configured to detect and/or track objects in the driving environment 110 and to recognize the objects. For example, the perception system 132 can analyze images captured by the cameras 129 and can be capable of detecting traffic light signals, road signs, roadway layouts (e.g., boundaries of traffic lanes, topologies of intersections, designations of parking places, and so on), presence of obstacles, and the like. The perception system 132 can further receive the lidar sensing data (coherent Doppler data and incoherent ToF data) to determine distances to various objects in the environment 110 and velocities (radial and, in some implementations, transverse, as described below) of such objects. In some implementations, the perception system 132 can use the lidar data in combination with the data captured by the camera(s) 129. In one example, the camera(s) 129 can detect an image of a scene, such as a construction zone scene. Using the data from the camera(s) 129, lidar data, etc., the perception system 132 can be capable of determining the existence of objects within the scene (e.g., cones). For example, the perception system 132 can include a scene recognition component 133.

The perception system 132 can further receive information from a GPS transceiver (not shown) configured to obtain information about the position of the AV relative to Earth. The GPS data processing module 134 can use the GPS data in conjunction with the sensing data to help accurately determine location of the AV with respect to fixed objects of the driving environment 110, such as roadways, lane boundaries, intersections, sidewalks, crosswalks, road signs, surrounding buildings, and so on, locations of which can be provided by map information 135. In some implementations, the data processing system 130 can receive non-electromagnetic data, such as sonar data (e.g., ultrasonic sensor data), temperature sensor data, pressure sensor data, meteorological data (e.g., wind speed and direction, precipitation data), and the like.

The data processing system 130 can further include an environment monitoring and prediction component 136, which can monitor how the driving environment 110 evolves with time, e.g., by keeping track of the locations and velocities of the animated objects (relative to Earth). In some implementations, the environment monitoring and prediction component 136 can keep track of the changing appearance of the environment due to motion of the AV relative to the environment. In some implementations, the environment monitoring and prediction component 136 can make predictions about how various animated objects of the driving environment 110 will be positioned within a prediction time horizon. The predictions can be based on the current locations and velocities of the animated objects as well as on the tracked dynamics of the animated objects during a certain (e.g., predetermined) period of time. For example, based on stored data for object 1 indicating accelerated motion of object 1 during the previous 3-second period of time, the environment monitoring and prediction component 136 can conclude that object 1 is resuming its motion from a stop sign or a red traffic light signal. Accordingly, the environment monitoring and prediction component 136 can predict, given the layout of the roadway and presence of other vehicles, where object 1 is likely to be within the next 3 or 5 seconds of motion. As another example, based on stored data for object 2 indicating decelerated motion of object 2 during the previous 2-second period of time, the environment monitoring and prediction component 136 can conclude that object 2 is stopping at a stop sign or at a red traffic light signal. Accordingly, the environment monitoring and prediction component 136 can predict where object 2 is likely to be within the next 1 or 3 seconds. The environment monitoring and prediction component 136 can perform periodic checks of the accuracy of its predictions and modify the predictions based on new data obtained from the sensing system 120.

The data generated by the perception system 132, the GPS data processing module 134, the environment monitoring and prediction component 136, and the motion planning blueprint generator 138 can be received by an autonomous driving system, such as AV control system (AVCS) 140. The AVCS 140 can include one or more algorithms that control how the AV is to behave in various driving situations and environments.

For example, the AVCS 140 can include a navigation system for determining a global driving route to a destination point. The AVCS 140 can also include a driving path selection system for selecting a particular path through the immediate driving environment, which can include selecting a traffic lane, negotiating a traffic congestion, choosing a place to make a U-turn, selecting a trajectory for a parking maneuver, and so on. The AVCS 140 can also include an obstacle avoidance system for safe avoidance of various obstructions (cones, rocks, stalled vehicles, a jaywalking pedestrian, and so on) within the driving environment of the AV. The obstacle avoidance system can be configured to evaluate the size of the obstacles and the trajectories of the obstacles (if obstacles are animated) and select an optimal driving strategy (e.g., braking, steering, accelerating, etc.) for avoiding the obstacles.

Algorithms and modules of AVCS 140 can generate instructions for various systems and components of the vehicle, such as the powertrain and steering 150, vehicle electronics 160, signaling 170, and other systems and components not explicitly shown in **FIG. 1****.** The powertrain and steering 150 can include an engine (internal combustion engine, electric engine, and so on), transmission, differentials, axles, wheels, steering mechanism, and other systems. The vehicle electronics 160 can include an on-board computer, engine management, ignition, communication systems, carputers, telematics, in-car entertainment systems, and other systems and components. The signaling 170 can include high and low headlights, stopping lights, turning and backing lights, horns and alarms, inside lighting system, dashboard notification system, passenger notification system, radio and wireless network transmission systems, and so on. Some of the instructions output by the AVCS 140 can be delivered directly to the powertrain and steering 150 (or signaling 170) whereas other instructions output by the AVCS 140 are first delivered to the vehicle electronics 160, which generate commands to the powertrain and steering 150 and/or signaling 170.

In one example, the AVCS 140 can determine that an obstacle identified by the data processing system 130 is to be avoided by decelerating the vehicle until a safe speed is reached, followed by steering the vehicle around the obstacle. The AVCS 140 can output instructions to the powertrain and steering 150 (directly or via the vehicle electronics 160) to 1) reduce, by modifying the throttle settings, a flow of fuel to the engine to decrease the engine rpm, 2) downshift, via an automatic transmission, the drivetrain into a lower gear, 3) engage a brake unit to reduce (while acting in concert with the engine and the transmission) the vehicle's speed until a safe speed is reached, and 4) perform, using a power steering mechanism, a steering maneuver until the obstacle is safely bypassed. Subsequently, the AVCS 140 can output instructions to the powertrain and steering 150 to resume the previous speed settings of the vehicle.

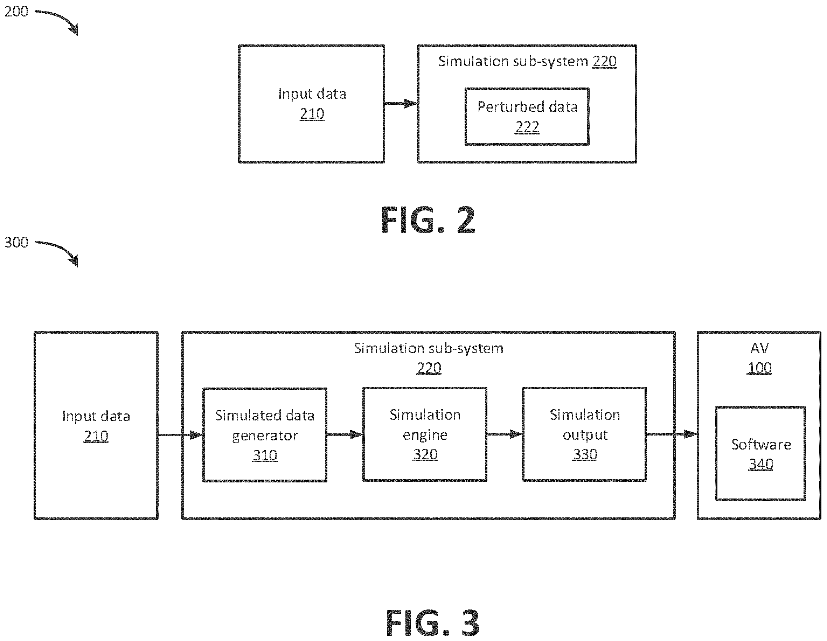

The functionality of the data processing system 130 and/or the AVCS 140 can be improved by updating one or more components of the data processing system 130 and/or the AVCS 140. For example, one or more components of the data processing system 130 and/or the AVCS 140 can be updated based on simulations performed using simulated log data. As will be described in further detail below with reference to **FIGS. 2-6****,** the simulated log data used to perform the simulations can be generated by perturbing real-world log data obtained by an AV during operation with a driving environment, such as the AV 100.

**FIG. 2** is a diagram illustrating an example system 200 for performing an autonomous vehicle (AV) driving simulation, in accordance with some implementations of the present disclosure. As shown, the system 200 can receive AV simulation input data ("input data") 210. The input data 210 can include a set of real-world log data obtained (e.g., collected) by an AV (e.g., the AV 100 of **FIG. 1**) during operation of the AV within a real-world driving environment. For example, the set of real-world log data can be log data generated at least in part by an AV control system of the AV (e.g., the AVCS 140 of the AV 100 of **FIG. 1**). The AV can operate in a fully autonomous driving mode, a manual driving mode, or a semi-autonomous driving mode. The input data 210 can be saved to storage for future simulation use. The set of real-world data can include at least one set of real-world parameters. Each set of real-world parameters can define a real-world object observed by the AV operating within a real-world driving environment. In some implementations, a real-world object is a real-world agent. Examples of real-world agents include, for example, other vehicles, pedestrians, bicyclists, animals, etc.

The system 200 can further include a simulation sub-system 220 that performs simulations using perturbed data 222. The simulation sub-system can include a processing device and/or can be executed by a processing device as software and/or firmware. The simulation sub-system 220 is configured to receive the input data 210, and perform a simulation using perturbed data 222 resulting from perturbing at least some of the input data 210 as described in more detail herein. The simulation is of a simulated AV operating in a simulated driving environment. For example, the simulation sub-system 220 can include a log-based simulator configured to perform a simulation based on simulated log data, and the simulation is of a simulated AV operating in a simulated driving environment defined by the simulated log data.

For example, as will be described in further detail below with reference to **FIG. 3****,** if the input data 210 includes a set of real-world log data, then the simulation sub-system 220 can be further configured to generate a set of simulated log data from the set of real-world log data. The set of simulated log data can be generated using at least one real-world log of the set of real-world log data. The set of simulated log data can include at least one set of simulated parameters. Each set of simulated parameters defines a simulated object within the simulated driving environment. For example, a simulated object can be a simulated agent. In some implementations, instead of the input data 210 including the set of real-world simulated data, the input data 210 can include the set of simulated data. For example, the set of simulated data can be generated by a component separate from the simulation sub-system

220 (not shown). That is, the set of simulated data can be generated prior to being received by the simulation sub-system 220.

Generating the set of simulated log data can include perturbing at least one real-world parameter of the at least one set of real-world parameters to obtain the perturbed data 222 including at least one set of simulated parameters. In some implementations, perturbing the at least one real-world parameter can include least one of: physically shifting an AV trajectory, physically shifting an object trajectory, temporally shifting the AV trajectory, temporally shifting the object trajectory, changing AV speed, changing object speed, changing one or more object dimensions, or changing an object type. A simulation can then be performed using perturbed data 222 including the set of simulated log data. Results of the simulation can be analyzed to determine the usefulness of the set of simulated log data (e.g., real-world log data in combination with the perturbations).

Illustratively, the at least one real-world log used to generate the set of simulated log data can be selected from the set of real-world log data (e.g., by a user) as being useful for perturbation. A set of trajectories can be constructed for each object defined by the at least one real-world log. Each trajectory can be constructed along with timings, dimensions, kinematics, and/or other characteristics relevant to AV planning and control. At simulation time, for at least one trajectory of the set of trajectories, the at least one object used to construct the at least one trajectory can be hidden (e.g., deleted) from the simulated AV sensors. For each trajectory, a set of parameters can be perturbed as described above to obtain at least one perturbed trajectory, in a manner specified by the end-user and/or programmatically. At each iteration of the simulation, according to each perturbed trajectory, a modified object position can be injected into the simulation to determine any simulated AV interaction (e.g., detection and/or reaction). Further details regarding performing and implementing the simulation will now be described below with reference to **FIG. 3****.**

**FIG. 3** is a diagram illustrating an example system 300 for performing and implementing an autonomous vehicle (AV) driving simulation, in accordance with some implementations of the present disclosure. The system 300 includes the input data 210 and the simulation sub-system 220 of **FIG. 2** and the AV of **FIG. 1****.** The simulation sub-system 220 can include a number of components.

For example, as shown, the simulation sub-system 220 can include a simulated data generator 310. In this illustrative example, it is assumed that the input data 210 includes a set of real-world log data obtained from an AV, as described above with reference to **FIGS. 1-2****.** It is further assumed that the simulated data generator 310 is configured to receive the set of real-world log data, and generate the set of simulated log data including the perturbed data 222 based on the set of real-world log data, as described above with reference to **FIG. 2****.** As further shown, the simulation sub-system 220 can further include a simulation engine 320 configured to perform a simulation based on the set of simulated log data. As described above with reference to **FIG. 2****,** the simulation is of a simulated AV operating in a simulated driving environment (e.g., a log-based simulation)

However, in other implementations, the input data 210 can include the set of simulated log data (e.g., the perturbed data 222). In such implementations, the simulation sub-system 220 may not include the simulated data generator 310 and the input data 210 can be received directly by the simulation engine 320 to perform the simulation. Alternatively, the simulation sub-system 220 can include the simulated data generator 310, but the input data 210 can be received directly by the simulation engine 320 to perform the simulation.

As shown, the simulation engine 320 can generate a simulation output 330. The simulation output 330 can reflect a performance of the simulated AV operating within the simulated driving environment. For example, the simulation output can indicate a number of negative events that occurred during the simulation (e.g., a number of collisions or near collisions).

The AV can include AV control software ("software") 340. The simulation output 330 can be used to improve one or more components of the AV 100 (e.g., the data processing system 130 and/or the AVCS 140 of **FIG. 1**) by updating and/or modifying the software 340. For example, simulation can be used to test an update to the AV control software, and the simulation output 330 can be used to determine whether the updated AV control software has performed satisfactorily during simulation. In some implementations, determining whether the updated AV control software has performed satisfactorily during simulation includes determining whether its performance satisfies a threshold condition. For example, determining whether the updated AV control software has performed satisfactorily during simulation can include determining whether the number of negative events occurred during simulation satisfies a threshold condition (e.g., the number of negative events is less than or equal to a threshold number of negative events).

If the updated AV control software is determined to have performed satisfactorily during simulation, this means that the performance of the simulated AV within the simulated driving environment was acceptable. Thus, the updated AV control software can be identified as validated and the update to the AV control software can be integrated within the AVCS 140 by updating the software 340 to improve the operation of the AV while in an autonomous driving mode.

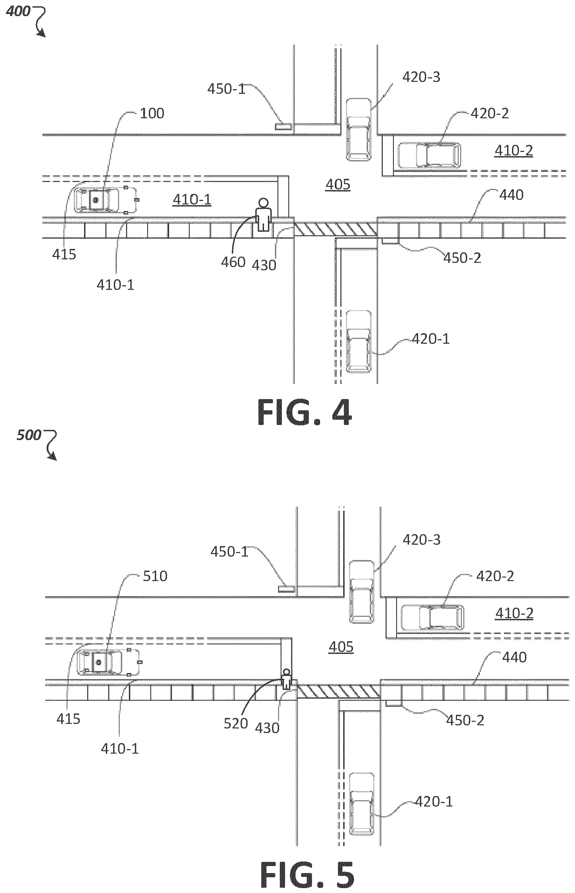

If the updated AV control software is determined to have performed unsatisfactory during simulation (i.e., failed), then the update to the AV control software can be identified as a failed update, and the issue(s) with the failed update can be addressed. Addressing the issues(s) with the failed update can include performing at least one of: flagging the failed update for review, analyzing the failed update to generate simulation metrics for review, modifying the update to improve operation of the simulated AV within the simulated driving environment, etc. Addressing the issues(s) with the failed update can further include modifying the update and performing a new simulation using the set of simulated log data, in accordance with the modified update, to obtain a new simulation output. If the new simulation output indicates that the modified update has performed satisfactorily, then the modified update can be integrated within the AV. Further details regarding performing and implementing AV driving simulations are described above with reference to **FIGS. 1-2** and will be described in further detail below with reference to **FIGS. 4-6****.**

**FIG. 4** is a diagram illustrating an example real-world driving environment 400, in accordance with some implementations of the present disclosure. As shown, the driving environment 400 includes the AV 100, intersection 405, lanes including lanes 410-1 and 410-2, a lane divider line 415 dividing the lanes 410-1 and 410-2, agent vehicles 420-1 through 420-3, crosswalk 430, sidewalk 440, stop signs 450-1 and 450-2, and pedestrian 460. Although each of the agent vehicles 420-1 through 420-3 are depicted as cars, the agent vehicles 420-1 through 420-3 can be any suitable vehicle (e.g., motorcycle, van, bus). Moreover, the pedestrian 460 may be, for example, a cyclist, an animal, etc.

The AV 100 can obtain a set of real-world log data during operation within the real-world driving environment (e.g., based on sensor data and/or event data obtained from the data processing system 130). The set of real-world log data can include log data as the AV 100 is approaching the intersection 405. For example, the AV 100 can be attempted to make a right turn. The AV 100 can obtain real-world log data with respect to the agent vehicles 420-1 through 420-3, which are also approaching the intersection 405. For example, the log data may indicate that the vehicle 420-3 (depicted as a car) does not stop at the stop sign 450-1. Additionally or alternatively, the AV 100 can further obtain log data with respect to the pedestrian 460. For example, the log data may indicate a speed of the pedestrian 460 crossing the street via the crosswalk 430, a dimensions of the pedestrian 406 (e.g., height), etc.

**FIG. 5** is a diagram illustrating an example simulated driving environment 500, in accordance with some implementations of the present disclosure. The simulated driving environment 500 can correspond to a simulation performed using a set of simulated log data generated from the set of real-world log data described above with reference to **FIG. 4****.** The set of simulated log data can be generated by perturbing one or more parameters of the set of real-world log data. In this illustrative example, the simulated driving environment 500 includes a simulated AV 510 and a simulated pedestrian 520. The simulated pedestrian 520 is generated by reducing the height and speed parameters of the pedestrian 460, as well as physically shifting the pedestrian 460 closer to both the crosswalk 430 and the lane occupied by the simulated AV 510. In this example, the simulated AV 510 is attempting to make a right turn at the intersection 405 while the simulated pedestrian 520 is attempting to cross the street via the crosswalk 430. The simulated pedestrian 520 is smaller and slower as compared to the pedestrian 460, and the position of the simulated pedestrian 520 has been translated with respect to the position of the pedestrian 460. Thus, due to at least these changes in parameters used to generate the set of simulated log data, the response of the simulated AV 510 to the simulated pedestrian 520 may change relative to the response of the AV 100 to the pedestrian 460. If the simulation output indicates poor performance in which the AV 510 is determined to have a negative event (e.g., a collision or near collision with the simulated pedestrian 520), then the simulation can be deemed a failure and remedial actions can be taken to improve how the AV control software reacts to the set of simulated log data.

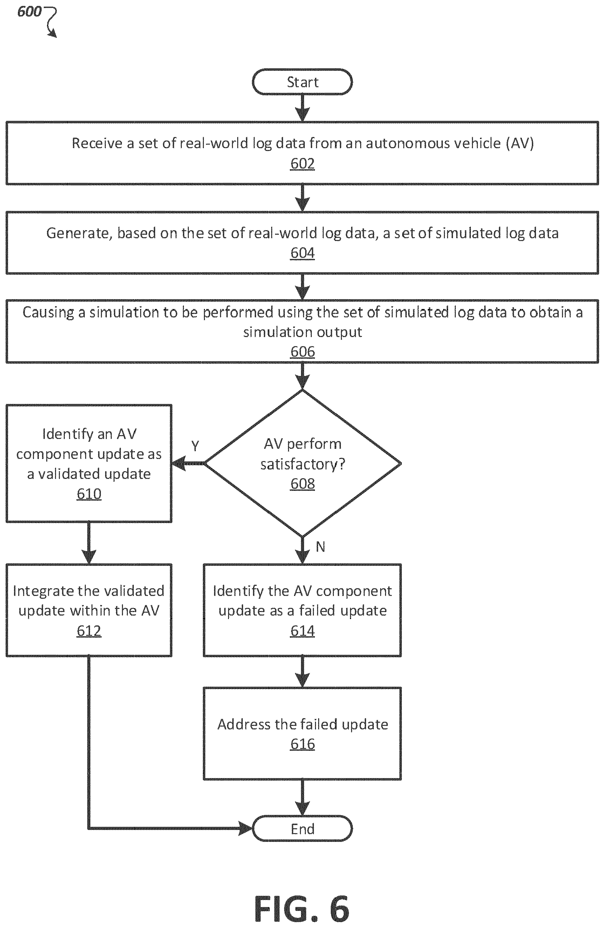

**FIG. 6** is a flow diagram of an example method 600 of increasing autonomous vehicle (AV) log data usefulness via perturbation, in accordance with some implementations of the present disclosure. The method 600 can be performed by processing logic that can include hardware (e.g., processing device, circuitry, dedicated logic, programmable logic, microcode, hardware of a device, integrated circuit, etc.), software (e.g., instructions run or executed on a processing device), or a combination thereof. For example, the processing logic can be included within a simulator (e.g., the simulation sub-system 220 of **FIG. 2**). Although shown in a particular sequence or order, unless otherwise specified, the order of the processes can be modified. Thus, the illustrated implementations should be understood only as examples, and the illustrated processes can be performed in a different order, and some processes can be performed in parallel. Additionally, one or more processes can be omitted in various implementations. Thus, not all processes are required in every implementation. Other process flows are possible.

At operation 602, the processing logic receives a set of real-world log data generated by an autonomous vehicle (AV). For example, the set of real-world log data can be generated at least in part by an AV control system of the AV (e.g., the AVCS 140 of the AV 100 of **FIG. 1**). The set of real-world log data can include at least one set of real-world parameters. Each set of real-world parameters defines a real-world object observed by the AV operating within a real-world driving environment. In some implementations, a real-world object is a real-world agent. Examples of real-world agents include, for example, other vehicles, pedestrians, bicyclists, animals, etc.

At operation 604, the processing logic generates, based on the set of real-world log data, a set of simulated log data. The set of simulated log data includes at least one set of simulated parameters. Each set of simulated parameters defines a simulated object within a simulated driving environment. In some implementations, generating the set of simulated log data includes perturbing at least one real-world parameter of the at least one set of real-world parameters to obtain the at least one set of simulated parameters. For example, perturbing the at least one parameter of the at least one set of real-world parameters can include least one of: physically shifting an AV trajectory, physically shifting an object trajectory, temporally shifting the AV trajectory, temporally shifting the object trajectory, changing AV speed, changing object speed, changing one or more object dimensions, or changing an object type.

At operation 606, the processing logic causes a simulation to be performed using the set of simulated log data to obtain a simulation output. The simulation is of an AV operating in the simulated driving environment defined by the set of simulated log data (e.g., the at least one set of simulated parameters). In some implementations, the simulation output reflects a performance of the AV operating within the simulated driving environment. For example, the simulation output can indicate a number of negative events that occurred during the simulation (e.g., a number of collisions or near collisions).

At operation 608, the processing logic determines whether the AV has performed satisfactorily during simulation. In some implementations, determining whether AV has performed satisfactorily includes determining whether its performance satisfies a threshold condition. For example, determining whether the AV has performed satisfactorily can include determining whether the number of negative events occurred during simulation satisfies a threshold condition (e.g., the number of negative events is less than or equal to a threshold number of negative events).

In some implementations, if simulation is used to test an update to a component (an update to a particular program, module, machine learning model or the like) of the AV, and the AV is determined to have performed satisfactorily during simulation, this means that the performance of the updated AV component within the simulated driving environment was acceptable. Thus, at operation 610, the processing logic identifies an AV component update as a validated update. At operation 612, the processing logic can integrate the validated update within the AV. For example, integrating the AV component update within the AV can include updating a particular program, module, machine learning model or the like within the data processing system 130 and/or the AVCS 140 of the AV 100 of **FIG. 1** to control the operation of the AV within a real-world driving environment. Thus, updating the AV component based on the simulation output can improve the operation of the AV while in an autonomous driving mode.

If the simulated AV is determined to have performed unsatisfactory during simulation (i.e., failed), then at operation 614, the processing logic identifies the AV component update as a failed update. At operation 616, the processing logic addresses the failed AV component update. Addressing the failed AV component update can include performing at least one of: flagging the failed update for review, analyzing the failed update to generate simulation metrics, modifying the failed update to improve operation of the simulated AV within the simulated driving environment defined by the at least one set of simulated log data, etc. Addressing the failed update can further include modifying the failed update and performing a new simulation using the set of simulated log data, in accordance with the modified update, to obtain a new simulation output. If the new simulation output indicates that the modified update has performed satisfactorily, then the modified update can be integrated within the AV (e.g., operation 612).

In some implementations, simulation is performed to test an existing component of the AV. In such implementations, if the simulated AV is determined to have performed satisfactorily during simulation, this means that the performance of the existing AV component within the simulated driving environment was acceptable. Thus, the processing logic identifies the existing AV component as validated, and no change to the existing AV component is needed. Alternatively, if the simulated AV is determined to have performed unsatisfactory during simulation, then the processing logic identifies the existing AV component as failed, and facilitates an update to the existing AV component by performing, for example, at least one of: flagging the failed AV component for review, analyzing the failed AV component to generate simulation metrics, modifying or reconfiguring (e.g., by changing the logic or configuration parameters) the failed AV component to improve operation of the simulated AV within the simulated driving environment defined by the at least one set of simulated log data, and performing a new simulation using the set of simulated log data, in accordance with the modified AV component, to obtain a new simulation output. If the new simulation output indicates that the modified AV component has performed satisfactorily, then the modified AV component can be integrated within the AV. Further details regarding operations 602-616 are described above with reference to **FIGS. 1-5****.**

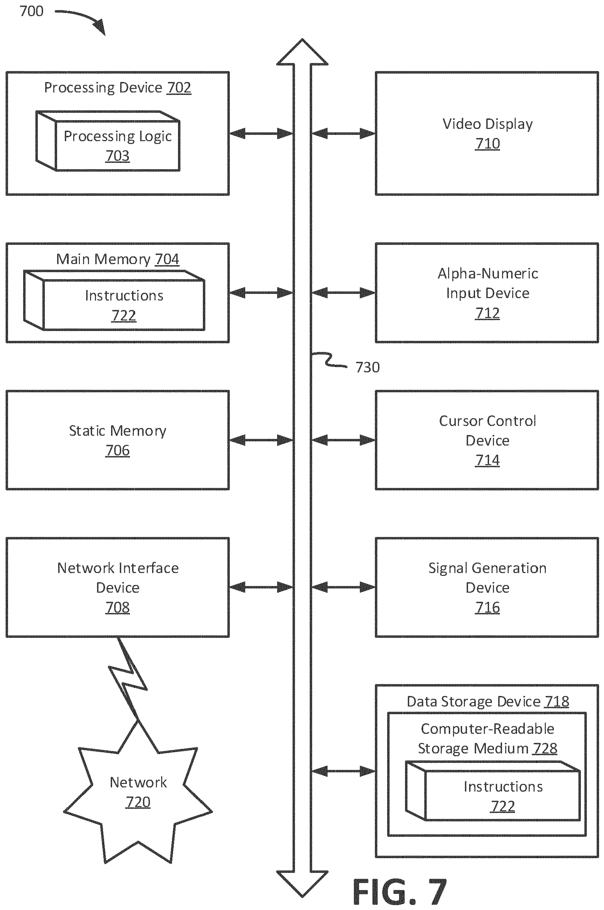

**FIG.** 7 depicts a block diagram of an example computer device 700 within which a set of instructions, for causing the machine to perform any of the one or more methodologies discussed herein can be executed, in accordance with some implementations of the disclosure. Example computer device 700 can be connected to other computer devices in a LAN, an intranet, an extranet, and/or the Internet. Computer device 700 can operate in the capacity of a server in a client-server network environment. Computer device 700 can be a personal computer (PC), a set-top box (STB), a server, a network router, switch or bridge, or any device capable of executing a set of instructions (sequential or otherwise) that specify actions to be taken by that device. Further, while only a single example computer device is illustrated, the term "computer" includes any collection of computers that individually or jointly execute a set (or multiple sets) of instructions to perform any one or more of the methods discussed herein. In some implementations, the AV 100 includes the computer device 700).

The computer device 700 can include a processing device 702 (also referred to as a processor or CPU), which can include processing logic 703, a main memory 704 (e.g., read-only memory (ROM), flash memory, dynamic random access memory (DRAM) such as synchronous DRAM (SDRAM), etc.), a static memory 706 (e.g., flash memory, static random access memory (SRAM), etc.), and a secondary memory (e.g., a data storage device 718), which can communicate with each other via a bus 730.

Processing device 702 represents one or more general-purpose processing devices such as a microprocessor, central processing unit, or the like. More particularly, processing device 702 can be a complex instruction set computing (CISC) microprocessor, reduced instruction set computing (RISC) microprocessor, very long instruction word (VLIW) microprocessor, processor implementing other instruction sets, or processors implementing a combination of instruction sets. Processing device 702 can also be one or more special-purpose processing devices such as an application specific integrated circuit (ASIC), a field programmable gate array (FPGA), a digital signal processor (DSP), network processor, or the like. In accordance with one or more aspects of the disclosure, processing device 702 can be configured to execute instructions performing any of the operations performed by the AV 100 and/or the simulation sub-system 220.

Example computer device 700 can further comprise a network interface device 808, which can be communicatively coupled to a network 720. Example computer device 700 can further comprise a video display 710 (e.g., a liquid crystal display (LCD), a touch screen, or a cathode ray tube (CRT)), an alphanumeric input device 712 (e.g., a keyboard), a cursor control device 714 (e.g., a mouse), and an acoustic signal generation device 716 (e.g., a speaker).

Data storage device 718 can include a computer-readable storage medium (or, more specifically, a non-transitory computer-readable storage medium) 728 on which is stored one or more sets of executable instructions 722. In accordance with one or more aspects of the disclosure, executable instructions 722 can comprise executable instructions to perform any of the operations of AVCS 140.

Executable instructions 722 can also reside, completely or at least partially, within main memory 704 and/or within processing device 702 during execution thereof by example computer device 700, main memory 704 and processing device 702 also constituting computer-readable storage media. Executable instructions 722 can further be transmitted or received over a network via network interface device 708.

While the computer-readable storage medium 728 is shown in **FIG. 7** as a single medium, the term "computer-readable storage medium" should be taken to include a single medium or multiple media (e.g., a centralized or distributed database, and/or associated caches and servers) that store the one or more sets of VM operating instructions. The term "computer-readable storage medium" includes any medium that is capable of storing or encoding a set of instructions for execution by the machine that cause the machine to perform any one or more of the methods described herein. The term "computer-readable storage medium" includes, but is not limited to, solid-state memories, and optical and magnetic media.

Some portions of the preceding detailed descriptions have been presented in terms of algorithms and symbolic representations of operations on data bits within a computer memory. These algorithmic descriptions and representations are the ways used by those skilled in the data processing arts to most effectively convey the substance of their work to others skilled in the art. An algorithm is here, and generally, conceived to be a self-consistent sequence of operations leading to a desired result. The operations are those requiring physical manipulations of physical quantities. Usually, though not necessarily, these quantities take the form of electrical or magnetic signals capable of being stored, combined, compared, and otherwise manipulated. It has proven convenient at times, principally for reasons of common usage, to refer to these signals as bits, values, elements, symbols, characters, terms, numbers, or the like.

It should be borne in mind, however, that all of these and similar terms are to be associated with the appropriate physical quantities and are merely convenient labels applied to these quantities. The disclosure can refer to the action and processes of a computer system, or similar electronic computing device, that manipulates and transforms data represented as physical (electronic) quantities within the computer system's registers and memories into other data similarly represented as physical quantities within the computer system memories or registers or other such information storage systems.

The disclosure also relates to an apparatus for performing the operations herein. This apparatus can be specially constructed for the intended purposes, or it can include a general purpose computer selectively activated or reconfigured by a computer program stored in the computer. Such a computer program can be stored in a computer readable storage medium, such as, but not limited to, any type of disk including floppy disks, optical disks, CD-ROMs, and magnetic-optical disks, read-only memories (ROMs), random access memories (RAMs), EPROMs, EEPROMs, magnetic or optical cards, or any type of media suitable for storing electronic instructions, each coupled to a computer system bus.

The algorithms and displays presented herein are not inherently related to any particular computer or other apparatus. Various general purpose systems can be used with programs in accordance with the teachings herein, or it can prove convenient to construct a more specialized apparatus to perform the method. The structure for a variety of these systems will appear as set forth in the description below. In addition, the disclosure is not described with reference to any particular programming language. It will be appreciated that a variety of programming languages can be used to implement the teachings of the disclosure as described herein.

The disclosure can be provided as a computer program product, or software, that can include a machine-readable medium having stored thereon instructions, which can be used to program a computer system (or other electronic devices) to perform a process according to the disclosure. A machine-readable medium includes any mechanism for storing information in a form readable by a machine (e.g., a computer). In some implementations, a machine-readable (e.g., computer-readable) medium includes a machine (e.g., a computer) readable storage medium such as a read only memory ("ROM"), random access memory ("RAM"), magnetic disk storage media, optical storage media, flash memory devices, etc. The words "example" or "exemplary" are used herein to mean serving as an example, instance, or illustration. Any aspect or design described herein as "example' or "exemplary" is not necessarily to be construed as preferred or advantageous over other aspects or designs. Rather, use of the words "example" or "exemplary" is intended to present concepts in a concrete fashion. As used in this application, the term "or" is intended to mean an inclusive "or" rather than an exclusive "or." That is, unless specified otherwise, or clear from context, "X includes A or B" is intended to mean any of the natural inclusive permutations. That is, if X includes A; X includes B; or X includes both A and B, then "X includes A or B" is satisfied under any of the foregoing instances. In addition, the articles "a" and "an" as used in this application and the appended claims may generally be construed to mean "one or more" unless specified otherwise or clear from context to be directed to a singular form. Moreover, use of the term "an implementation," "one implementation," "some implementations," "an implementation," "one implementation," "some implementations," or the like throughout may or may not mean the same implementation or implementation. One or more implementations or implementations described herein may be combined in a particular implementation or implementation. The terms "first," "second," "third," "fourth," etc. as used herein are meant as labels to distinguish among different elements and may not necessarily have an ordinal meaning according to their numerical designation.

In the foregoing specification, implementations of the disclosure have been described with reference to specific example implementations thereof. It will be evident that various modifications can be made thereto without departing from the broader spirit and scope of implementations of the disclosure as set forth in the following claims. The specification and drawings are, accordingly, to be regarded in an illustrative sense rather than a restrictive sense.

This specification includes the following clauses:
Clause 1. A system comprising:
   a memory device; and
   a processing device, operatively coupled to the memory device, to perform operations comprising:
      receiving a set of real-world log data defining a real-world driving environment and generated by an autonomous vehicle (AV), wherein the set of real-world log data comprises at least one set of real-world parameters defining at least one real-world object observed by the AV operating within the real-world driving environment;
      generating, based on the set of real-world log data, a set of simulated log data defining a simulated driving environment, wherein the set of simulated log data comprises at least one set of simulated parameters defining at least one simulated object within the simulated driving environment, and wherein generating the set of simulated log data comprises perturbing at least one real-world parameter of the at least one set of real-world parameters to obtain the at least one set of simulated parameters; and
      causing a simulation to be performed using the set of simulated log data to obtain a simulation output.
Clause 2. The system of clause 1, wherein the at least one real-world object comprises at least one agent observed by the AV.
Clause 3. The system of clause 1, wherein perturbing the at least one parameter of the at least one set of real-world parameters comprises at least one of: physically shifting an AV trajectory, physically shifting an object trajectory, temporally shifting the AV trajectory, temporally shifting the object trajectory, changing AV speed, changing object speed, changing one or more object dimensions, or changing an object type.
Clause 4. The system of clause 1, wherein the simulation output reflects AV performance within the simulated driving environment, and wherein the operations further comprise determining whether the simulation output indicates that the AV performance satisfies a threshold condition.
Clause 5. The system of clause 4, wherein the simulation output indicates a number of negative events that occurred during the simulation, and wherein determining whether the simulation output indicates that the performance satisfies the threshold condition comprises determining whether the number of negative events is less than or equal to a threshold number of negative events.
Clause 6. The system of clause 4, wherein the operations further comprise: in response to determining that the simulation output indicates that the AV performance satisfies the threshold condition, identifying an update to a component of the AV that was used during the simulation as a validated update; and integrating the validated update within the AV.
Clause 7. The system of clause 4, wherein the operations further comprise:
   in response to determining that the simulation output indicates that the AV performance does not satisfy the threshold condition, identifying an update to a component of the AV that was used during the simulation as a failed update; and
   addressing the failed update.
Clause 8. The system of clause 7, wherein addressing the failed update comprises performing at least one of: flagging the failed update for review, analyzing the failed update to generate simulation metrics for review, or obtaining a modified update to improve operation of the simulated AV within the simulated driving environment.
Clause 9. A method comprising:
   receiving, by a processing device, a set of real-world log data defining a real-world driving environment and generated by an autonomous vehicle (AV), wherein the set of real-world log data comprises at least one set of real-world parameters defining at least one real-world object observed by the AV operating within the real-world driving environment;
   generating, by the processing device based on the set of real-world log data, a set of simulated log data defining a simulated driving environment, wherein the set of simulated log data comprises at least one set of simulated parameters defining at least one simulated object within the simulated driving environment, and wherein generating the set of simulated log data comprises perturbing at least one real-world parameter of the at least one set of real-world parameters to obtain the at least one set of simulated parameters; and
   causing, by the processing device, a simulation to be performed using the set of simulated log data to obtain a simulation output.
Clause 10. The method of clause 9, wherein perturbing the at least one parameter of the at least one set of real-world parameters comprises at least one of: physically shifting an AV trajectory, physically shifting an object trajectory, temporally shifting the AV trajectory, temporally shifting the object trajectory, changing AV speed, changing object speed, changing one or more object dimensions, or changing an object type.
Clause 11. The method of clause 9, wherein the simulation output reflects AV performance within the simulated driving environment, and wherein the method further comprises determining, by the processing device, whether the simulation output indicates that the AV performance satisfies a threshold condition.
Clause 12. The method of clause 11, wherein the simulation output indicates a number of negative events that occurred during the simulation, and wherein determining whether the simulation output indicates that the performance satisfies the threshold condition comprises determining whether the number of negative events is less than or equal to a threshold number of negative events.
Clause 13. The method of clause 11, further comprising:
   in response to determining that the simulation output indicates that the AV performance satisfies the threshold condition, identifying, by the processing device, an update to a component of the AV that was used during the simulation as a validated update; and
   integrating, by the processing device, the validated update within the AV.
Clause 14. The method of clause 11, further comprising:
   in response to determining that the simulation output indicates that the AV performance does not satisfy the threshold condition, identifying, by the processing device, an update to a component of the AV that was used during the simulation as a failed update; and
   addressing, by the processing device, the failed update.
Clause 15. The method of clause 14, wherein addressing the failed update comprises performing at least one of: flagging the failed update for review, analyzing the failed update to generate simulation metrics for review, or obtaining a modified update to improve operation of the simulated AV within the simulated driving environment.
Clause 16. A non-transitory computer-readable storage medium having instructions stored thereon that, when executed by a processing device, cause the processing device to perform operations comprising:
   generating, based on a set of real-world log data defining a real-world driving environment and generated by an autonomous vehicle (AV), a set of simulated log data defining a simulated driving environment, wherein the set of simulated log data comprises at least one set of simulated parameters defining at least one simulated object within the simulated driving environment, and wherein generating the set of simulated log data comprises perturbing at least one real-world parameter of the at least one set of real-world parameters to obtain the at least one set of simulated parameters;
   causing a simulation to be performed using the set of simulated log data to obtain a simulation output reflecting AV performance within the simulated driving environment;
   determining whether the simulation output indicates that the AV performance satisfies a threshold condition;
   in response to determining that the simulation output indicates that the AV performance does not satisfy the threshold condition, identifying an update to a component of the AV that was used during the simulation as a failed update; and
   addressing the failed update.
Clause 17. The non-transitory computer-readable storage medium of clause 16, wherein perturbing the at least one parameter of the at least one set of real-world parameters comprises at least one of: physically shifting an AV trajectory, physically shifting an object trajectory, temporally shifting the AV trajectory, temporally shifting the object trajectory, changing AV speed, changing object speed, changing one or more object dimensions, or changing an object type.
Clause 18. The non-transitory computer-readable storage medium of clause 16, wherein the simulation output indicates a number of negative events that occurred during the simulation, and wherein determining whether the simulation output indicates that the performance satisfies the threshold condition comprises determining whether the number of negative events is less than or equal to a threshold number of negative events.
Clause 19. The non-transitory computer-readable storage medium of clause 16, wherein addressing the failed update comprises performing at least one of: flagging the failed update for review, analyzing the failed update to generate simulation metrics for review, or obtaining a modified update to improve operation of the simulated AV within the simulated driving environment.
Clause 20. The non-transitory computer-readable storage medium of clause 18, wherein the operations further comprise:
   in response to determining that the simulation output indicates that the AV performance satisfies the threshold condition, identifying an update to a component of the AV that was used during the simulation as a validated update; and
   integrating the validated update within the AV.

## Claims

1. A method comprising:
receiving, by a processing device, a set of real-world log data defining a real-world driving environment and generated by an autonomous vehicle (AV), wherein the set of real-world log data comprises at least one set of real-world parameters defining at least one real-world object observed by the AV operating within the real-world driving environment;
generating, by the processing device based on the set of real-world log data, a set of simulated log data defining a simulated driving environment, wherein the set of simulated log data comprises at least one set of simulated parameters defining at least one simulated object within the simulated driving environment, and wherein generating the set of simulated log data comprises perturbing at least one real-world parameter of the at least one set of real-world parameters to obtain the at least one set of simulated parameters; and
causing, by the processing device, a simulation to be performed using the set of simulated log data to obtain a simulation output.

2. The method of claim 1, comprising testing AV control software using the simulation performed using the set of simulated log data.

3. The method of claim 2, wherein the simulation output is indicative of a performance, in the simulated driving environment, of a simulated AV that is controlled using the AV control software.

4. The method of any one of the preceding claims, wherein the at least one real-world object comprises at least one agent observed by the AV.

5. The method of any one of the preceding claims, wherein perturbing the at least one parameter of the at least one set of real-world parameters comprises at least one of:
physically shifting an AV trajectory, physically shifting an object trajectory, temporally shifting the AV trajectory, temporally shifting the object trajectory, changing AV speed,
changing object speed, changing one or more object dimensions, or changing an object type.

6. The method of any one of the preceding claims, wherein the simulation output reflects AV performance within the simulated driving environment, and wherein the method further comprises determining, by the processing device, whether the simulation output indicates that the AV performance satisfies a threshold condition.

7. The method of claim 6, wherein the simulation output indicates a number of negative events that occurred during the simulation, and wherein determining whether the simulation output indicates that the performance satisfies the threshold condition comprises determining whether the number of negative events is less than or equal to a threshold number of negative events.

8. The method of claim 6 or claim 7, further comprising:
in response to determining that the simulation output indicates that the AV performance satisfies the threshold condition, identifying, by the processing device, an update to a component of the AV that was used during the simulation as a validated update; and
integrating, by the processing device, the validated update within the AV.

9. The method of claim 6 or claim 7, further comprising:
in response to determining that the simulation output indicates that the AV performance does not satisfy the threshold condition, identifying, by the processing device, an update to a component of the AV that was used during the simulation as a failed update; and
addressing, by the processing device, the failed update, and optionally wherein addressing the failed update comprises performing at least one of: flagging the failed update for review, analyzing the failed update to generate simulation metrics for review, or obtaining a modified update to improve operation of the simulated AV within the simulated driving environment.

10. A system comprising:
a memory device; and
a processing device, operatively coupled to the memory device, to cause performance of the method of any one of claims 1 to 9.

11. A non-transitory computer-readable storage medium having instructions stored thereon that, when executed by a processing device, cause the processing device to perform operations comprising:
generating, based on a set of real-world log data defining a real-world driving environment and generated by an autonomous vehicle (AV), a set of simulated log data defining a simulated driving environment, wherein the set of simulated log data comprises at least one set of simulated parameters defining at least one simulated object within the simulated driving environment, and wherein generating the set of simulated log data comprises perturbing at least one real-world parameter of the at least one set of real-world parameters to obtain the at least one set of simulated parameters;
causing a simulation to be performed using the set of simulated log data to obtain a simulation output reflecting AV performance within the simulated driving environment;
determining whether the simulation output indicates that the AV performance satisfies a threshold condition;
in response to determining that the simulation output indicates that the AV performance does not satisfy the threshold condition, identifying an update to a component of the AV that was used during the simulation as a failed update; and
addressing the failed update.

12. The non-transitory computer-readable storage medium of claim 11, wherein perturbing the at least one parameter of the at least one set of real-world parameters comprises at least one of: physically shifting an AV trajectory, physically shifting an object trajectory, temporally shifting the AV trajectory, temporally shifting the object trajectory, changing AV speed, changing object speed, changing one or more object dimensions, or changing an object type.

13. The non-transitory computer-readable storage medium of claim 11, wherein the simulation output indicates a number of negative events that occurred during the simulation, and wherein determining whether the simulation output indicates that the performance satisfies the threshold condition comprises determining whether the number of negative events is less than or equal to a threshold number of negative events.

14. The non-transitory computer-readable storage medium of claim 11, wherein addressing the failed update comprises performing at least one of: flagging the failed update for review, analyzing the failed update to generate simulation metrics for review, or obtaining a modified update to improve operation of the simulated AV within the simulated driving environment.

15. The non-transitory computer-readable storage medium of claim 13, wherein the operations further comprise:
in response to determining that the simulation output indicates that the AV performance satisfies the threshold condition, identifying an update to a component of the AV that was used during the simulation as a validated update; and
integrating the validated update within the AV.
